# FASCICULE DE BREVET EUROPEEN

(11) **EP 3 985 437 B1**
(45) Date de publication et mention de la délivrance du brevet: **02.04.2025**
(21) Numéro de dépôt: 21200408.9
(22) Date de dépôt: 01.10.2021
(51) Int. Cl.: G03F 1/38, G03F 7/20, H01L 21/768, H01L 23/544, H05K 1/02

(54) **PROCEDE DE FABRICATION D'UN ENSEMBLE DE COMPOSANTS ELECTRONIQUES SUR LA FACE AVANT D'UNE PLAQUE SEMI-CONDUCTRICE**
VERFAHREN ZUR HERSTELLUNG EINER ELEKTRONISCHEN BAUGRUPPE AUF DER VORDERSEITE EINES HALBLEITERWAFERS
METHOD FOR MANUFACTURING A SET OF ELECTRONIC COMPONENTS ON THE FRONT FACE OF A SEMICONDUCTOR PLATE

(30) Priorité: 16.10.2020 FR 2010600
(43) Date de publication de la demande: 20.04.2022
(73) Titulaire: STMicroelectronics France, 92120 Montrouge (FR)
(72) Inventeur: NONGAILLARD, Matthieu, 38000 GRENOBLE (FR); OHEIX, Thomas, 38000 GRENOBLE (FR)
(74) Mandataire: Cabinet Beaumont

(56) Documents cités:
- EP-A2- 1 427 014
- WO-A1-2008/069212
- JP-A- 2000 252 176
- US-A1- 2010 279 231
- US-B2- 8 187 897
- DWYER L ET AL: "Lithographic Chip Identification: Meeting the Failure Analysis Challenge", SPIE INTEGRATED CIRCUIT METROLOGY, INSPECTION AD PROCESS CONTROL VI,, vol. 1673, no. 43, 1 January 1992 (1992-01-01), pages 1 - 13, XP002768776

## Description

### DOMAINE DE L'INVENTION

La présente invention concerne le domaine des semi-conducteurs. Plus précisément, la présente invention porte sur un procédé de fabrication d'un ensemble de composants électroniques sur une plaque semi-conductrice permettant la localisation de tout ou partie de ces composants sur la plaque.

### ARRIERE PLAN TECHNOLOGIQUE DE L'INVENTION

Dans l'industrie des semi-conducteurs, une méthode habituelle pour fabriquer des composants électroniques en grande quantité est d'élaborer un ensemble de composants électroniques identiques sur une plaque semi-conductrice. Afin de former sur la plaque un empilement de couches formant les composants électroniques, on recourt généralement à des techniques de photolithographie. Le principe de ces techniques est bien connu : une couche de matériau est déposée sur la totalité de la plaque, puis une photorésine est déposée sur la couche. Un masque photolithographique est alors appliqué au-dessus de la photorésine, au niveau d'un premier champ dit champ d'exposition et représentant une fraction de la surface de la plaque semi-conductrice. Dans le premier champ d'exposition, la partie non couverte par le masque est alors exposée à la lumière, transformant localement la photorésine. La séquence d'application du masque photolithographique et d'exposition à la lumière est répétée successivement sur chacun des autres champs d'exposition. La résine transformée est ensuite retirée, et la couche est localement gravée selon le motif du masque, sur toute la surface de la plaque semi-conductrice, avant que la photorésine subsistante ne soit à son tour retirée. Le processus est ainsi répété pour chaque couche de l'empilement, en utilisant à chaque fois un masque photolithographique différent.

Lorsque l'ensemble des composants électroniques est formé sur la plaque, celle-ci est découpée autour de chaque composant, pour former une puce qui est ensuite individuellement encapsulée dans un boîtier. Habituellement, les équipements de préhension et transfert des puces (« pick-and-place » selon la terminologie anglo-saxonne) assurent informatiquement la correspondance entre chaque puce (composant) et la plaque semi-conductrice dont elle provient.

Mais en cas de défaillance d'un composant, il peut être souhaitable de remonter à la localisation précise du composant électronique sur la plaque, de manière à vérifier les paramètres physiques des couches lors de la fabrication dans la zone correspondante de la plaque et à faciliter l'analyse de défaillance.

La traçabilité du composant électronique peut être réalisée au moment de l'assemblage, c'est-à-dire lorsque le composant est encapsulé, avec un marquage spécifique sur le boîtier. Toutefois, cette opération, souvent réalisée par un opérateur manuel, entraîne des coûts et un temps de production importants. En outre, elle n'est pas adaptée si le composant n'est pas encapsulé dans un boîtier, et est peu adaptée à la production de masse.

Certaines lignes d'assemblage proposent une solution semi-manuelle, avec un prélèvement, la constitution d'un fichier de correspondance entre la position du composant sur la plaque et le numéro du boîtier, ainsi qu'une sérialisation du boîtier, suivie par l'opérateur. Toutefois, toutes ces opérations nécessitent l'intervention d'opérateurs humains, ce qui peut être source d'erreur.

Le document US8187897 présente un procédé de fabrication d'un ensemble de composants électroniques sur une plaque semi-conductrice. Un motif individuel est apposé sur l'une des couches du composant électronique, qui constitue un identifiant unique du composant permettant de tracer la plaque dont il est issu ainsi que sa position sur la plaque.

Toutefois, cette approche présente l'inconvénient d'une certaine complexité de mise en œuvre, notamment en ce qu'il nécessite l'application de masques photolithographiques supplémentaires, par rapport à un procédé classique de fabrication d'un ensemble de composants, pour générer un motif spécifique pour chaque composant. Une telle application entraîne un coût et un temps de production additionnels.

Le document WO2008/069212 décrit une plaquette semiconductrice et un procédé de fabrication de dispositifs semiconducteurs à partir de cette plaquette.

### OBJET DE L'INVENTION

La présente invention concerne une solution alternative à celles de l'état de la technique, et vise à remédier à tout ou partie des inconvénients précités. Elle concerne en particulier un procédé de fabrication d'un ensemble de composants électroniques sur une plaque semi-conductrice permettant la localisation de chaque composant électronique sur la plaque après sa découpe, sans nécessiter d'étape photolithographique supplémentaire lors de l'élaboration de l'ensemble de composants électroniques.

### BREVE DESCRIPTION DE L'INVENTION

En vue de la réalisation de ce but, l'objet de l'invention propose un procédé de fabrication d'un ensemble de composants électroniques sur la face avant d'une plaque semi-conductrice présentant une pluralité de zones de champ, chaque zone comprenant au moins un champ et chaque champ comprenant au moins un composant électronique, le procédé comprenant une pluralité d'étapes de photolithographie pour former un empilement de couches constituant chaque composant électronique, chaque étape de photolithographie comprenant l'application d'un masque successivement sur chaque champ dans un équipement de photolithographie.

Le procédé de fabrication selon l'invention est remarquable en ce que l'un des masques comprend en outre un motif d'identification, ledit masque étant désigné masque d'identification, et en ce que, à l'étape de photolithographie associée au masque d'identification, au moins un paramètre photolithographique de l'équipement de photolithographie est différent pour chaque zone de champ, de manière à exposer différemment le motif d'identification dans chaque zone de champ.

Ainsi, à l'issue de l'étape de photolithographie associée au masque d'identification, une marque d'identification spécifique à chaque zone de champ est formée car la résolution spatiale du motif d'identification dont ladite marque est issue diffère entre chaque zone de champ.

Selon d'autres caractéristiques avantageuses et non limitatives de l'invention, prises seules ou selon toute combinaison techniquement réalisable :
- la pluralité d'étapes de photolithographie comprend une étape d'ouverture de contacts des composants électroniques, le masque d'identification étant le masque appliqué à ladite étape d'ouverture de contacts ;
- le paramètre photolithographique est choisi parmi la dose d'exposition et la focalisation ;
- la dose d'exposition varie entre 5 mJ/cm² et 1000 mJ/cm² ;
- la focalisation varie de +/-10 µm ;
- le motif d'identification présente au moins une dimension de l'ordre de quelques µm, typiquement comprise entre 1 micron et 20 microns ;
- les composants électroniques comprennent des transistors à haute mobilité électronique à base de matériaux III-N ;
- au moins une zone de champ comprend une pluralité de champs ;
- chaque zone de champ comprend une pluralité de champs.

### BREVE DESCRIPTION DES FIGURES

D'autres caractéristiques et avantages de l'invention ressortiront de la description détaillée de l'invention qui va suivre en référence aux figures annexées sur lesquels :
[Fig. 1] La figure 1 représente une plaque semi-conductrice présentant un ensemble de composants électroniques obtenue par un procédé de fabrication selon l'invention ;
[Fig. 2] La figure 2 représente différents exemples de motifs d'identification selon l'invention ;
[Fig. 3] La figure 3 représente différentes marques d'identification selon l'invention obtenues à partir de différents motifs d'identification et pour des paramètres photolithographiques différents.

Les figures sont des représentations schématiques qui, dans un objectif de lisibilité, ne sont pas nécessairement à l'échelle. Les mêmes références sur les figures pourront être utilisées pour des éléments de même nature. Les différentes possibilités (variantes et modes de réalisation illustrés et/ou détaillés dans la description à suivre) doivent être comprises comme n'étant pas exclusives les unes des autres et peuvent se combiner entre elles.

### DESCRIPTION DETAILLEE DE L'INVENTION

L'invention concerne un procédé de fabrication d'un ensemble de composants électroniques. On entend par composant électronique tout composant de taille micrométrique à millimétrique, constitué d'un empilement de couches, capable d'utiliser des courants électriques pour transmettre, traiter ou stocker des informations. Chaque composant électronique peut ainsi être constitué ou comprendre par exemple une résistance, un condensateur, une bobine, un transistor, un circuit intégré, toute combinaison ou tout assemblage de ces éléments, ou bien encore d'autres éléments ou assemblages d'éléments bien connus de l'homme du métier.

De préférence, mais sans que cela ne soit limitatif de l'invention, les composants électroniques peuvent notamment comprendre des transistors à haute mobilité électronique élaborés sur un substrat à base de matériaux III-N.

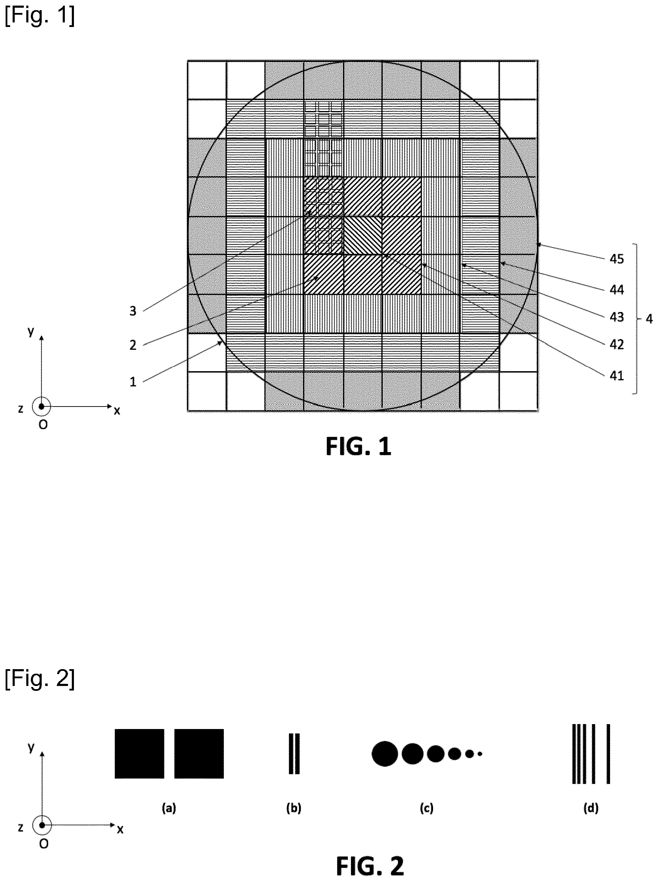

Plus généralement, les composants électroniques 3 sont formés sur une face avant d'une plaque semi-conductrice 1 (figure 1). La plaque semi-conductrice 1 se présente préférentiellement sous la forme d'un substrat circulaire, de diamètre compris entre 100 mm et 450 mm, et d'épaisseur comprise entre 100 et 1500 microns. La plaque semi-conductrice 1 peut être constituée de tout matériau semi-conducteur, par exemple du silicium et plus spécifiquement comme énoncé précédemment d'une superposition de matériaux III-N.

Bien entendu, l'invention n'est aucunement limitée à de telles formes, dimensions ou composition de la plaque semi-conductrice 1.

La face avant de la plaque semi-conductrice 1 définit un plan (x,y), l'empilement de couches formant les composants électroniques étant élaboré selon un axe normal z à ce plan (x, y). L'élaboration de cet empilement requiert une succession d'étapes dites de production, à savoir des étapes de dépôt de couches, de lithographie pour définir la structuration de ladite couche, de gravure pour structurer la couche, de traitements de surface, etc.

Comme cela a été rappelé dans la partie introductive de la présente demande, lors d'une étape de lithographie ou photolithographie de production, l'application d'un masque photolithographique et l'exposition à la lumière sont opérées au niveau d'un champ 2 (également appelé champ d'exposition 2). Un champ 2 peut comprendre un seul composant électronique ou une pluralité de composants électroniques 3, typiquement entre deux et plusieurs centaines. Par souci de simplification sur la figure 1, des composants 3 n'ont été représentés que sur quatre champs 2, en l'occurrence neuf composants 3 par champ 2.

Comme cela est visible sur la figure 1, la face avant de la plaque semi-conductrice 1 présente une pluralité de zones de champs 4 (l'exemple de la figure 1 représente schématiquement cinq zones de champs 41, 42, 43, 44, 45). Chaque zone 4 comprend au moins un champ 2, préférentiellement une pluralité de champs 2. Le nombre et la répartition des champs dans chaque zone 4 peuvent être identiques pour toutes les zones 4, ou différents d'une zone à l'autre. Comme cela sera décrit ultérieurement, l'invention prévoit la possibilité de regrouper plusieurs champs 2 en zones 4 de champ, de telle sorte que les champs 2 d'une même zone 4 aient des caractéristiques similaires, tandis que les champs 2 de zones 4 différentes présentent des caractéristiques différentes reconnaissables.

Ainsi, sur l'exemple schématique de la figure 1, la première zone 41 comprend un unique champ 2, positionné au centre de la plaque semi-conductrice 1. La deuxième zone 42 comprend huit champs 2, la troisième zone 43 comprend seize champs 2, la quatrième zone 44 comprend vingt-quatre champs 2, et la cinquième zone 45 comprend vingt champs 2. Par souci de simplification, les composants 3 par champ 2 ont été représentés uniquement sur deux champs de la deuxième zone 42 et sur un champ des troisième 43 et quatrième 44 zones.

La forme et la taille des zones 4 peuvent être librement choisies. Préférentiellement, lorsque la plaque semi-conductrice 1 est un substrat circulaire, les zones 4 peuvent être choisies de manière à être concentriques, comme sur l'exemple de la figure 1. Alternativement, les zones 4 peuvent représenter une portion de la plaque semi-conductrice 1, par exemple la moitié ou un quart de la plaque. Les zones 4 peuvent également être des tranches de la plaque semi-conductrice 1 selon l'un ou l'autre des axes x et y, sans que l'invention ne soit aucunement limitée à de telles répartitions de zones.

Revenant au procédé de fabrication selon l'invention, un tel procédé comprend une pluralité d'étapes de photolithographie de production pour former un empilement de couches constituant chaque composant électronique 3. Ces étapes de photolithographie sont entrecoupées d'autres étapes bien connues permettant la formation de l'empilement, tel que des étapes de traitement thermique, de dépôt, de gravure, de nettoyage, de dopage ou de polissage. Les différentes étapes de formation d'un empilement constituant un composant électronique sont tout à fait classiques et connues de l'homme du métier et ne seront que succinctement évoquées.

Les étapes de traitement thermique sont ainsi réalisées dans des fours, typiquement à des températures comprises entre 400 et 1200°C, afin de réaliser les couches d'oxyde ou de nitrure de silicium, ou opérer un réarrangement des réseaux cristallins. Les étapes de dépôt peuvent être effectuées par diverses techniques physiques ou chimiques connues, telles que le dépôt en phase vapeur, la pulvérisation, ou l'épitaxie par exemple, en fonction du type de couches souhaité et de la compatibilité notamment en température de l'empilement. Les couches déposées peuvent être de natures diverses : semi-conductrices, isolante ou conductrices.

Au cours de chaque étape de photolithographie, la plaque semi-conductrice 1 est disposée dans un équipement de photolithographie (non représenté). Après qu'une couche de photorésine ait été déposée, généralement sur la totalité de la surface de la plaque 1, chaque étape de photolithographie comprend l'application d'un masque successivement sur chaque champ 2. Lorsqu'il est appliqué sur un champ 2, ce dernier est exposé à une source lumineuse de faible longueur d'onde, généralement ultraviolet ou rayons X, afin de projeter l'image du masque dans la couche de photorésine, formant une structure dans la couche de photorésine.

Les étapes de gravures peuvent être réalisées au moyen de gravures humides ou de gravures sèches, afin de reproduire la structure de la couche de photorésine dans la couche de matériau située en-dessous. La structure peut consister par exemple en un arrangement de doigts interdigités pour former les électrodes de grille, de source et de drain d'un transistor, ou en un réseau d'ouvertures pour former des vias conducteurs électrique d'interconnexion, ou encore en une pluralité de plots de contact pour connecter chaque composant 3. Dans tous les cas, la structure est ici fonctionnelle, c'est-à-dire que sa forme et sa disposition sont définies pour rendre fonctionnel le composant électronique 3.

De manière générale, lorsque le composant électronique 3 comprend un transistor, l'empilement obtenu comprend une couche active semi-conductrice, sur laquelle sont superposées une pluralité de couches d'interconnexion, et enfin une couche supérieure de passivation.

Une fois l'ensemble des composants électroniques 3 formé sur la plaque 1, celle-ci est découpée autour de chaque composant 3, formant une puce qui est ensuite individuellement encapsulée dans un boîtier.

Dans le procédé de fabrication conforme à l'invention, l'un des masques utilisés au cours de l'une des étapes de photolithographie de production comprend, outre le (ou les) motif(s) dit fonctionnel(s) utilisé(s) pour former les structures fonctionnelles de l'empilement, un motif d'identification. Parce qu'il porte ce motif supplémentaire, ledit masque est désigné « masque d'identification » dans la présente description.

Selon l'invention, à l'étape de photolithographie associée au masque d'identification, au moins un paramètre photolithographique de l'équipement de photolithographie est différent pour chaque zone 4 de champ, de manière à exposer différemment le motif d'identification dans chaque zone 4 de champ. Pour le dire autrement, à l'étape de photolithographie associée au masque présentant le motif d'identification, ce masque d'identification est appliqué au-dessus de chaque champ 2, successivement ; et lorsque le masque quitte une zone 4 de champ pour entrer dans une autre, au moins un paramètre photolithographique de l'équipement de photolithographie est modifié. Bien entendu, la variation du paramètre photolithographique est maîtrisée et sa valeur associée à la zone 4 en question.

De la sorte, la forme du motif d'identification sur la photorésine, et de la marque d'identification ensuite formé dans la couche en-dessous, est différente d'une zone 4 à une autre. Ainsi, après la découpe d'un composant électronique 3, il est possible de reconnaître la zone 4 de la plaque 1 d'où provient le composant 3 en question en analysant la forme de la marque d'identification, laquelle est associée au paramètre lithographique ayant permis de la former et donc à la zone 4 de la plaque semi-conductrice 1 d'où elle provient. Le procédé de fabrication selon l'invention permet donc, sans réaliser d'étape de photolithographie supplémentaire (c'est-à-dire en effectuant uniquement les étapes de photolithographie de production), et notamment sans masque supplémentaire à appliquer, d'identifier la localisation de composants 3 par zone 4 de la plaque semi-conductrice 1, par la simple variation maîtrisée d'un paramètre photolithographique d'une zone 4 à une autre.

Ainsi, dans l'exemple représenté sur la figure 1, les composants 3 des deux champs de la deuxième zone 42 présenteront une marque d'identification identique, mais différente des composants des champs de la troisième zone 43 et de la quatrième zone 44, eux-mêmes différents entre eux.

Bien que la forme et les dimensions du motif d'identification puissent être librement choisies, il est nécessaire de pouvoir identifier et caractériser, pour chaque zone 4, la déformation de la marque d'identification en fonction du paramètre photolithographique.

Des exemples de motifs d'identification sont représentés sur la figure 2. Ainsi, le motif d'identification peut être une ouverture rectiligne d'une épaisseur donnée dessinée sur le masque (figure 2(a)), deux barres d'épaisseur et d'écartement données (figure 2(b)), une pluralité de disques de diamètre décroissant alignés dans une direction et espacés d'une distance fixe ou variable (figure 2(c)), une pluralité de barres d'écartement croissant dans une direction (figure 2(d)). Mais l'invention n'est évidemment pas limitée à de tels exemples de motifs.

Les caractéristiques (dimensions précitées et formes des motifs) des motifs d'identification dépendent du type de résine utilisée à l'étape de photolithographie associée au masque d'identification. Pour être sensible aux modifications de paramètres lithographiques, les motifs d'identification présentent avantageusement des dimensions de l'ordre de l'épaisseur de la résine.

Le paramètre photolithographique qui varie d'une zone à l'autre est un paramètre qui modifie l'exposition du motif d'identification d'une zone à l'autre. Il peut notamment être choisi parmi la dose d'exposition ou la focalisation. La dose d'exposition correspond à l'énergie lumineuse reçu par la résine et la focalisation correspond à un réglage de netteté (mise au point). Bien entendu, plusieurs paramètres peuvent varier, simultanément ou alternativement, et d'autres paramètres modifiant l'exposition peuvent être envisagés. Dans tous les cas, la valeur de ce(s) paramètres sera associée à chaque zone 4 de la plaque semi-conductrice 1.

Lorsque le paramètre photolithographique qui varie est la dose d'exposition, celle-ci peut typiquement varier entre 5 mJ/cm2 et 1000 mJ/cm2.

Lorsque le paramètre photolithographique qui varie est la focalisation, celle-ci peut typiquement varier de +/- 10 µm.

Ces gammes de variation de la dose et de la focalisation sont suffisamment larges pour envisager des variations significatives champs à champs.

Il en découle que la résolution spatiale du motif d'identification, dont est issue la marque d'identification, pour les composants de chaque zone de champ sera spécifique et diffèrera d'une zone de champ à l'autre.

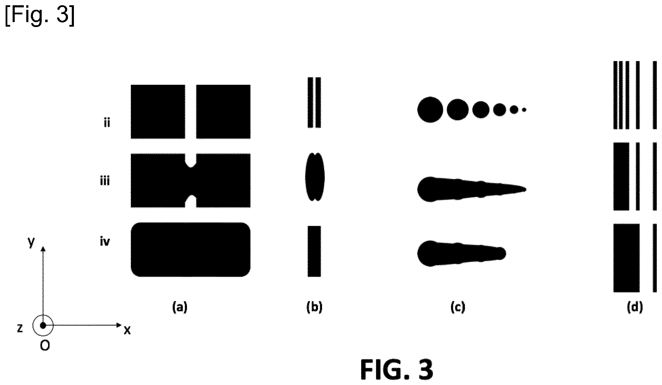

Des exemples de marques d'identification, formées à partir des motifs d'identification représentés sur la figure 2, sont représentés sur la figure 3 pour les trois zones 42, 43, 44 (respectivement désignées par les points ii, iii et iv). Le paramètre photolithographique ayant varié d'une zone à l'autre est ici la dose d'exposition, qui a diminué de la deuxième 42 à la troisième zone 43, puis de la troisième 43 à la quatrième zone 44.

Ainsi, si l'on part du motif d'identification de la figure 2(a), on constate que l'ouverture rectiligne, parfaitement reproduite lorsque la dose d'exposition est maximale (figure 3(a)ii), n'est pas entièrement reproduite lorsque la dose d'exposition est intermédiaire (figure 3(a)iii) et n'est plus du tout reproduite lorsque la dose d'exposition est minimale (figure 3(a)iv).

La dose d'exposition maximale peut correspondre à une valeur nominale de la dose d'exposition, cette valeur étant diminuée pour les autres zones par rapport à la valeur nominale. Bien entendu, cette situation n'est pas limitative de l'invention, et il est possible que la dose d'exposition nominale corresponde à la valeur intermédiaire, la dose d'exposition variant au-dessus ou en-dessous de cette valeur suivant les zones, ou bien à la valeur minimale, la dose d'exposition augmentant pour les autres zones par rapport à la valeur nominale.

Selon un autre exemple, si l'on part du motif d'identification de la figure 2(b), on constate que les deux barres, parfaitement reproduites lorsque la dose d'exposition est maximale (figure 3(b)ii), se recouvrent tout en permettant de distinguer deux formes distinctes lorsque la dose d'exposition est intermédiaire (figure 3(b)iii), et ne forment qu'une unique barre lorsque la dose d'exposition est minimale (figure 3(b)iv).

De même, si l'on part du motif d'identification de la figure 2(c), on constate que la pluralité de disques est parfaitement définie, chaque disque étant parfaitement distinct, lorsque la dose d'exposition est maximale (figure 3(c)ii), que les différentes formes se recouvrent partiellement lorsque la dose d'exposition est intermédiaire (figure 3(c)iii), et que les disques de diamètres les plus petits ne sont plus reproduits lorsque la dose d'exposition est minimale (figure 3(c)iv).

Selon encore un autre exemple, si l'on part du motif d'identification de la figure 2(d), on constate que la pluralité de barres est parfaitement reproduite lorsque la dose d'exposition est maximale (figure 2(d)ii). Lorsque la dose d'exposition est intermédiaire, les trois barres ayant un espacement le plus faible se recouvrent (figure 2(d)iii). Enfin, lorsque la dose d'exposition est minimale, les quatre barres ayant un espacement le plus faible se recouvrent.

Il est ainsi possible, en reconnaissant la forme de la marque d'identification de chacun des composants, d'associer cette forme à une dose d'exposition donnée, et plus généralement à un paramètre photolithographique donné, et donc d'associer cette forme à la zone de champ 4 de la plaque 1 de laquelle le composant 3 est issu.

Bien entendu, la dimension du motif d'identification doit être suffisamment petite et le motif d'identification doit être suffisamment éloigné des motifs fonctionnels du masque d'identification afin que la marque d'identification formée par le motif d'identification n'affecte pas l'intégrité des structures fonctionnelles de la couche considérée et des couches inférieures ou supérieures.

Typiquement, tandis que les dimensions surfaciques des structures fonctionnelles de la couche active d'un composant dans le plan formé par la face avant de la plaque semi-conductrice 1 sont de l'ordre de 10 nm² à 10⁵ µm², ou que les dimensions des contacts des composants à la surface de la couche supérieure de passivation sont typiquement de l'ordre de 10⁶ µm², les dimensions du motif d'identification peuvent être de l'ordre de 20 µm². La distance sur le masque d'identification entre un motif structurel et le motif d'identification pourra typiquement être choisie supérieure à 1 µm.

A titre d'exemple, on peut mentionner une ouverture de contact de l'ordre de 500 µm à 2000 µm et des marques d'identification de l'ordre de 5 à 10 µm, issues d'un motif d'identification présent sur le masque d'ouverture de contact.

Ainsi, afin de ne pas affecter les couches les plus complexes et fonctionnelles de l'empilement, il est préférable que le masque d'identification soit un masque appliqué pour former une couche éloignée de la couche active. En outre, il est préférable que la couche choisie pour recevoir le motif d'identification soit détectable sur le composant électronique après sa fabrication. Par conséquent, l'étape photolithographique correspondant à l'ouverture des contacts électriques des composants électroniques, généralement opérée sur la couche supérieure de passivation, est particulièrement adaptée à la mise en œuvre du masque d'identification. La marque d'identification est alors disposée sur la couche supérieure de passivation, qui présente l'avantage d'être visible dans le cadre d'un contrôle visuel. Une observation au microscope optique du composant nu permettra alors d'identifier la localisation d'origine de celui-ci sur la plaque. Bien entendu, d'autres méthodes optiques que la simple observation au microscope optique peuvent être employées pour analyser les marques d'identification, comme une analyse optique au moyen d'un logiciel de reconnaissance de motifs par exemple.

Un procédé de fabrication conforme à l'invention permet donc d'obtenir une plaque semi-conductrice sur la face avant de laquelle est disposé un ensemble de composants électroniques disposés. La plaque semi-conductrice présente une pluralité de zones de champs, chaque composant électronique occupant un champ de la face avant de la plaque, chaque zone comprenant au moins un champ, chaque composant électronique étant constitué d'un empilement de couches. Chacun des composants comprend une marque d'identification issue d'un motif d'identification. La résolution spatiale et donc la forme de ces marques d'identification diffère entre chaque zone de champ. Ainsi, cette marque d'identification est différente pour chaque zone 4, afin de permettre, une fois la découpe de la structure électronique autour de chaque composant électronique 3 réalisée, de pouvoir identifier la zone 4 de la plaque 1 de laquelle le composant électronique 3 est issu.

Bien entendu l'invention n'est pas limitée aux modes de mise en œuvre décrits et on peut y apporter des variantes de réalisation sans sortir du cadre de l'invention tel que défini par les revendications.

## Revendications

1. Procédé de fabrication d'un ensemble de composants électroniques (3) sur une face avant d'une plaque semi-conductrice (1) présentant une pluralité de zones de champ (4), chaque zone (4) comprenant au moins un champ (2) et chaque champ (2) comprenant au moins un composant électronique (3), le procédé comprenant une pluralité d'étapes de photolithographie pour former un empilement de couches constituant chaque composant électronique (3), chaque étape de photolithographie comprenant l'application d'un masque successivement sur chaque champ (2) dans un équipement de photolithographie, l'un des masques comprenant un motif d'identification et étant désigné masque d'identification ;
le procédé de fabrication étant **caractérisé en ce que**, à l'étape de photolithographie associée au masque d'identification, au moins un paramètre photolithographique de l'équipement de photolithographie est différent pour chaque zone de champ (4), de manière à exposer différemment le motif d'identification dans chaque zone de champ (4).

2. Procédé de fabrication selon la revendication précédente, dans lequel la pluralité d'étapes de photolithographie comprend une étape d'ouverture de contacts des composants électroniques (3), le masque d'identification étant le masque appliqué à ladite étape d'ouverture de contacts.

3. Procédé de fabrication selon l'une des revendications précédentes, dans lequel le paramètre photolithographique est choisi parmi la dose d'exposition et la focalisation.

4. Procédé de fabrication selon la revendication précédente, dans lequel la dose d'exposition varie entre 5 mJ/cm² et 1000 mJ/cm².

5. Procédé de fabrication selon l'une des deux revendications précédentes, dans lequel la focalisation varie de +/-10 µm.

6. Procédé de fabrication selon l'une des revendications précédentes, dans lequel le motif d'identification présente au moins une dimension de l'ordre de quelques µm, typiquement comprise entre 1 micron et 20 microns.

7. Procédé de fabrication selon l'une des revendications précédentes, dans lequel les composants électroniques (3) comprennent des transistors à haute mobilité électronique à base de matériaux III-N.

8. Procédé de fabrication selon l'une des revendications précédentes, dans lequel chaque zone de champ (4) comprend une pluralité de champs (2).

## Patentansprüche

1. Verfahren zur Herstellung einer Anordnung von elektronischen Bauelementen (3) auf der Vorderseite eines Halbleiterwafers (1), der eine Vielzahl von Feldbereichen (4) aufweist, wobei jeder Bereich (4) mindestens ein Feld (2) aufweist und jedes Feld (2) mindestens ein elektronisches Bauelement (3) aufweist, wobei das Verfahren eine Vielzahl von Photolithographieschritten aufweist, um einen Stapel von Schichten zu bilden, die jedes elektronische Bauelement (3) bilden, wobei jeder Photolithographieschritt das Aufbringen einer Maske nacheinander auf jedes Feld (2) in einer Photolithographie-Anlage aufweist, wobei eine der Masken ein Identifikationsmuster aufweist, wobei die Maske als Identifikationsmaske bezeichnet wird;
wobei das Herstellungsverfahren **dadurch gekennzeichnet ist, dass** bei dem mit der Identifikationsmaske verbundenen Photolithographieschritt mindestens ein photolithographischer Parameter der Photolithographie-Anlage für jeden Feldbereich (4) unterschiedlich ist, um das Identifikationsmuster in jedem Feldbereich (4) unterschiedlich zu belichten.

2. Herstellungsverfahren nach dem vorhergehenden Anspruch, wobei die Vielzahl von Photolithographieschritten einen Schritt des Öffnens von Kontakten der elektronischen Bauelemente (3) aufweist, wobei die Identifikationsmaske die Maske ist, die bei dem Schritt des Öffnens der Kontakte angewendet wird.

3. Herstellungsverfahren nach einem der vorhergehenden Ansprüche, wobei der photolithographische Parameter aus der Belichtungsdosis und der Fokussierung ausgewählt wird.

4. Herstellungsverfahren nach dem vorhergehenden Anspruch, wobei die Belichtungsdosis zwischen 5 mJ/cm² und 1000 mJ/cm² variiert.

5. Herstellungsverfahren nach einem der beiden vorhergehenden Ansprüche,
wobei die Fokussierung um +/-10 µm variiert.
vorhergehenden

6. Herstellungsverfahren nach einem der vorstehenden Ansprüche, wobei das Identifikationsmuster mindestens eine Abmessung in der Größenordnung von einigen µm, typischerweise im Bereich von 1 Mikrometer bis 20 Mikrometer, aufweist.

7. Herstellungsverfahren nach einem der vorhergehenden Ansprüche, wobei die elektronischen Bauelemente (3) Transistoren mit hoher Elektronenbeweglichkeit auf der Basis von III-N-Materialien aufweisen.

8. Herstellungsverfahren nach einem der vorhergehenden Ansprüche, wobei jeder Feldbereich (4) eine Vielzahl von Feldern (2) aufweist.

## Claims

1. Method of manufacturing an assembly of electronic components (3) on the front surface of a semiconductor wafer (1) comprising a plurality of field areas (4), each area (4) comprising at least one field (2) and each field (2) comprising at least one electronic component (3), the method comprising a plurality of photolithography steps to form a stack of layers forming each electronic component (3), each photolithography step comprising the application of a mask successively on each field (2) in photolithography equipment, one of the masks comprises an identification pattern, said mask being called identification mask;
the manufacturing method being **characterized in that**, at the photolithography step associated with the identification mask, as least one photolithographic parameter of the photolithography equipment is different for each field area (4), to expose the identification pattern differently in each field area (4).

2. Manufacturing method according to the foregoing claim, wherein the plurality of photolithography steps comprises a step of openings of contacts of the electronic components (3), the identification mask being the mask applied at said contact opening step.

3. Manufacturing method according to one of the foregoing claims, wherein the photolithographic parameter is selected from among the exposure dose and the focusing.

4. Manufacturing method according to the foregoing claim, wherein the exposure dose varies between 5 mJ/cm² and 1,000 mJ/cm².

5. Manufacturing method according to one of the two foregoing claims, wherein the focusing varies by +/-10 µm.

6. Manufacturing method according to one of the foregoing claims, wherein the identification pattern has at least one dimension in the order of a few µm, typically in the range from 1 micrometer to 20 micrometers.

7. Manufacturing method according to one of the foregoing claims, wherein the electronic components (3) comprise high electron mobility transistors based on III-N materials.

8. Manufacturing method according to one of the foregoing claims, wherein each field area (4) comprises a plurality of fields (2).
